# EUROPÄISCHE PATENTSCHRIFT

(11) **EP 0 976 310 B1**
(45) Veröffentlichungstag und Bekanntmachung des Hinweises auf die Patenterteilung: **10.07.2002**
(21) Anmeldenummer: 98928097.9
(22) Anmeldetag: 31.03.1998
(51) Int. Cl.: H05K 7/14

(54) **ELEKTRISCHES GERÄT MIT ZWEI IDENTISCH AUFGEBAUTEN GEHÄUSESCHALEN**
ELECTRICAL APPLIANCE WITH TWO IDENTICALLY BUILT CASING SHELLS
APPAREIL ELECTRIQUE A DEUX CAPOTS DE BOITIER IDENTIQUES

(30) Priorität: 14.04.1997 DE 19715521
(43) Veröffentlichungstag der Anmeldung: 02.02.2000
(73) Patentinhaber: SIEMENS AKTIENGESELLSCHAFT, 80333 München (DE)
(72) Erfinder: ROYER, Fritz, D-92256 Hahnbach (DE); WILHELM, Gerhard, D-92245 Kümmersbruck (DE)
(86) Internationale Anmeldenummer: DE9800915
(87) Internationale Veröffentlichungsnummer: WO9847336

(56) Entgegenhaltungen:
- EP-A- 0 154 570
- DE-A- 3 026 247
- DE-U- 29 606 759
- DE-U- 29 720 511
- US-A- 5 402 322

## Beschreibung

Die Erfindung bezieht sich auf ein elektrisches Gerät mit einem Gehäuse, das aus zwei identisch ausgeführten Gehäusehalbschalen zusammengesetzt ist, die spiegelverkehrt zueinander montiert sind.

Ein gattungsgemäßes Gerät ist aus der DE 296 06 759 U1 bereits bekannt. Hier ist ein mehrteiliges Gehäuse in Modulbauweise zur Aufnahme einer Leiterplatte offenbart. Dabei ist an ein mehrteiliges Gehäuse für Niederspannungs-Schaltgeräte, wie z.B. Zeitrelais, Termistorschutzgeräte, zur Aufnahme einer Leiterplatte gedacht. Das.Gehäuse ist hier parallel zur Montageebene in ein Gehäuseunter- und -oberteil geteilt. Die Leiterplatte ist entlang zweier einander gegenüberliegender Kanten treppenförmig abgestuft ausgebildet und mit Anschlußsteckern zum Aufstecken von in Blockform ausgebildeten Schraubklemmen im Bereich der treppenförmigen Abstufungen ausgerüstet. Die Anschlußstecker weisen neben Kontaktstiften noch Befestigungsstifte auf, die ggf. als hakenförmige verrastbare Befestigungsstifte ausgeführt sind.

Aus der DE 30 26 247 C2 ist ein anreihbares Gehäuse für die Montage auf einer Tragschiene offenbart. In das Gehäuse ist eine Schaltungsplatte einsetzbar, an deren Rändern elektrische Anschlußelemente angeordnet sind. Die Anschlußelemente ragen teilweise aus den Öffnungen des Gehäuses heraus. Die Teilung des Gehäuses besteht hier senkrecht zur Montagerichtung in Gehäuselängsrichtung.

Der Erfindung liegt die Aufgabe zugrunde, ein elektrisches Gerät der obengenannten Art durch Schaffung eines Gehäuses mit einem einfachen kostengünstigen Aufbau, das montagefreundlich und aus wenigen Teilen besteht, zu schaffen, wobei die Befestigung durch Aufschnappen geschehen soll, ohne daß eine Beeinträchtigung durch den üblichen Verzug der Gehäuseschalen einhergeht. Die Aufgabe wird durch ein elektrisches Gerät gemäß den Merkmalen nach Anspruch 1 gelöst. Die durch die beiden Gehäuseschalen gebildete Trennungsfuge verläuft hier nicht durch die zur Schnappbefestigung vorgesehenen Anformungen, so daß ein Verzug der Gehäuseschalen keine Erschwernisse bei der Montage nach sich zieht.

Eine besonders vorteilhafte Weiterbildung der Erfindung besteht, wenn beide Gehäuseschalen durch angeformte Rastelemente miteinander verbunden sind.

Eine besonders vorteilhafte Ausführung der Anschlußklemmen, insbesondere ihres Anschlusses, ist gegeben, wenn im Innenraum des Gehäuses eine Leiterplatte mit mindestens zwei Klemmenträgern montiert ist, die in die Leiterplatte geschnappt werden und deren zu Anschlußklemmen gehörige Anschlußfahnen durch Verlötung mit der Leiterplatte in elektrischer Verbindung stehen.

Weiterhin ist es vorteilhaft, wenn im elektrischen Gerät Anschlußklemmen integriert sind und zur Erweiterung um weitere Anschlußklemmen jeweils an einer Seitenwand der beiden Gehäuseschalen ein Klemmenblock mit Anschlußklemmen aufrastbar ist, in die bei Aufrastung aus dem Gehäuse hervorragende Anschlußfahnen von Klemmenträgern hineingleiten.

Eine weitere vorteilhafte Ausbildung der Erfindung besteht, wenn das Schaltgerät frontseitig mindestens einen Drehknopf als Einstellelement mit einer Verstellsicherung aufweist, die darin besteht, daß auf dem Drehknopf ein mechanisch kodiertes Eine weitere vorteilhafte Ausbildung der Erfindung besteht, wenn das Schaltgerät frontseitig mindestens einen Drehknopf als Einstellelement mit einer Verstellsicherung aufweist, die darin besteht, daß auf dem Drehknopf ein mechanisch kodiertes Schild aufrastbar ist, wobei die mechanische Kodierung des Schildes einer bestimmten Stellung des Drehknopfes entspricht.

Ein Ausführungsbeispiel der Erfindung wird im folgenden anhand einer Zeichnung näher erläutert. Es zeigen:
- FIG 1: eine perspektivische Ansicht ein aus zwei identisch aufgebauten Gehäuseschalen zusammensetzbares Gehäuses,
- FIG 2: eine perspektivische Ansicht eines erfinderischen elektrischen Geräts in teilweise geöffnetem Zustand,
- FIG 3: eine perspektivische Ansicht eines Klemmenträgers,
- FIG 4: eine Seitenansicht des Klemmträgers nach FIG 3,
- FIG 5: eine perspektivische Ansicht eines als Verstellsicherung dienenden Schildes und
- FIG 6: eine perspektivische Ansicht eines elektrischen Gerät mit einer plombierbaren Frontabdeckung.

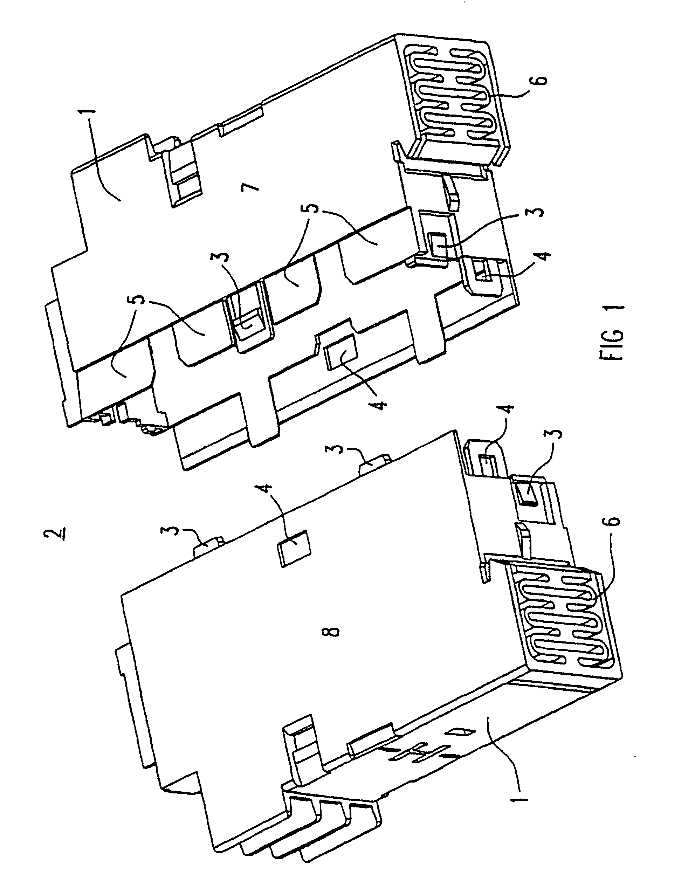

In FIG 1 sind zwei identisch aufgebaute, spiegelverkehrt zueinander liegende Gehäuseschalen 1 dargestellt, die mittels Rastelementen 3,4 an ihren Rändern zu einem Gehäuse 2 eines erfindungsgemäßen elektrischen Geräts zusammensetzbar sind. Die Rastelemente 3,4 bestehen wie üblich aus angeformten Rasthaken 3 und angepaßten Ausnehmungen 4. Zur Stabilisierung des zusammengefügten Gehäuses 2 sowie zur einfacheren Montage weisen die Gehäuseschalen 1 an ihren Rändern Stege 5 auf, die einerseits aufgrund ihrer Führungsfunktion die Montage erleichtern und andererseits aufgrund der Überlappung mit Seitenwänden der jeweils anderen Gehäuseschale 1 stabilisierend wirken. An ihren die Rückwand des Gehäuses 2 bildenden Seitenwänden der Gehäuseschalen 1 ist je ein Federrasthaken 6 angeformt. Sie dienen zur Schnappbefestigung des Gehäuses 2 auf einer Montageschiene und ermöglichen eine Demontage, ohne daß ein Werkzeug benötigt wird. Der in der Gehäuseschale 1 integrierte Federrasthaken 6 ist bezüglich seiner Kraft-Wegkennlinie so dimensioniert, daß die Vorspannung im aufgerasteten Zustand genügt, bei einem definierten maximalen Gerätegewicht bei definierten maximalen Beschleunigungen das Gerät sicher zu fixieren.

Die Trennungsfuge beider Gehäuseschalen 1 im montierten Zustand führt durch die Symmetrieachsen zweier gegenüberliegender Seitenwände 7 und 8 und außerhalb der Federrasthaken 6 entlang.

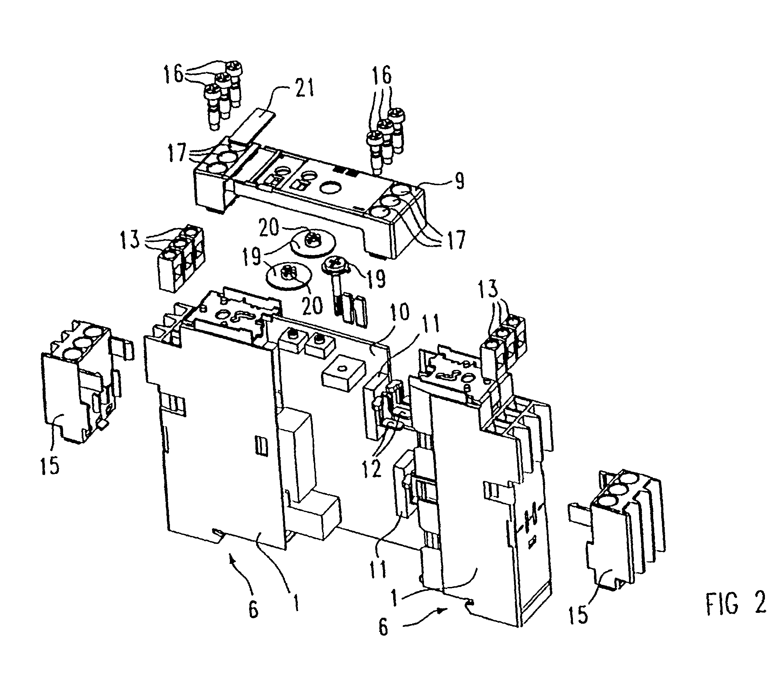

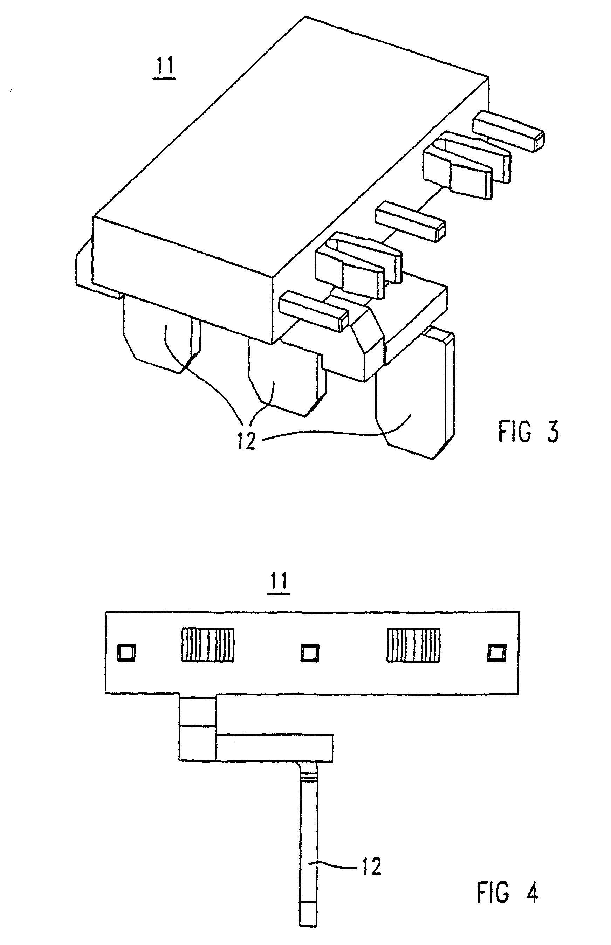

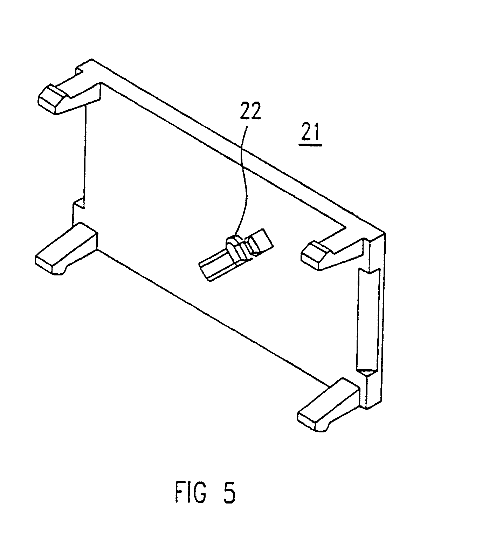

FIG 2 zeigt eine perspektivische Ansicht des erfindungsgemäßen elektrischen Geräts, wobei die eine Gehäuseschale 1 sowie eine die beiden Gehäuseschalen 1 im montierten Zustand übergreifende Frontabdeckung 9 abgenommen ist. In der dargestellten Gehäuseschale 1 steckt eine zum elektrischen Gerät gehörige Leiterplatte 10, an deren Ränder mehrere Klemmenträger 11 montiert sind. Die Klemmenträger 11 sind jeweils 3-polig ausgeführt, d.h. sie besitzen drei umspritzte Anschlußfahnen 12. Die Klemmenträger 11 (siehe auch FIG 3 und 4) werden zur Montage zunächst in die Leiterplatte 10 eingerastet und dann verlötet. Die auf diese Weise mit der Leiterplatte 10 kontaktierten Anschlußfahnen 12 der Klemmträger 11 gleiten beim Montieren der Leiterplatte 10 in den Gehäuseschalen 1 in hier nur angedeutete Klemmkäfige 13, die in entsprechend ausgeführte Taschen der Gehäuseschalen 1 eingeführt sind. Die Anschlußfahnen 13 der den Federrasthaken 6 benachbarten Klemmenträger 11 ragen seitlich aus dem Gehäuse 2 heraus und können zur Erweiterung um weitere Anschlußklemmen verwendet werden, wozu Klemmenblöcke 15 in diesem Bereich des Gehäuses 2 aufgerastet werden. Auf diese Weise können die üblicherweise 6-poligen Geräte auf 12 Pole erweitert werden.

Das Gehäuse 2 ist frontseitig durch einen Deckel 16 abdeckbar. Die zu den gehäuseseitigen Anschlußklemmen gehörigen, nicht dargestellten Klemmschrauben werden nach Aufsetzen des Deckels 16 von außen über Schraubenöffnungen 17 montiert und über hier nicht sichtbare integrierte Rastnasen 18 im Bereich der Schraubenöffnungen 17 gegen Verlieren gesichert.

Die Klemmenträger 15 sind gemäß FIG 3 und 4 symmetrisch gestaltet, was einen um 180° versetzen Einbau an den verschiedenen Einbaupositionen auf der Leiterplatte 10 ermöglicht. Somit genügt nur eine einzige Ausführung eines Klemmenträgers 11 zur Abdeckung aller Anwendungen.

An der Frontseite des elektrischen Gerätes gemäß FIG 2 befinden sich Einstellelemente, die über Drehknöpfe 19 betätigbar sind. Die Drehknöpfe 19 weisen mechanische Kodierungen 20 auf, deren Lage sich mit dem Drehwinkel des jeweiligen Drehknopfes 19 entsprechend ändert. Durch entsprechend mechanisch kodierte, auf die mechanischen Kodierungen der Drehknöpfe 19 aufrastbare Schilder 21 gemäß FIG 5 können die Drehknöpfe 19 gegen unbeabsichtigtes Verstellen geschützt werden. Auf je dem Schild 21 ist der zur Drehstellung passende Einstellwert bzw. die passende Einstellfunktion in Klartext bzw. in grafischer Darstellung aufgebracht. Ein bestimmtes Schild 21 kann aufgrund der mechanischen Kodierung zwischen dem Drehknopf 19 und dem Schild 21 nur aufgerastet werden, wenn sich der Drehknopf 19 in der dazu passenden Stellung befindet. So ist es möglich, durch unterschiedliche Lage der Rastnasen 22 ein Kodieren zwischen mehreren Gerätevarianten zu erreichen. Somit wird auf einfache und kostengünstige Weise die reine Funktionseinstellung über Drehknöpfe 19 realisiert mit der Zusatzfunktion einer Verstellsicherung und sichtbarer Zuordnung von Einstellwert bzw. Funktion in Klartext und grafischer Darstellung.

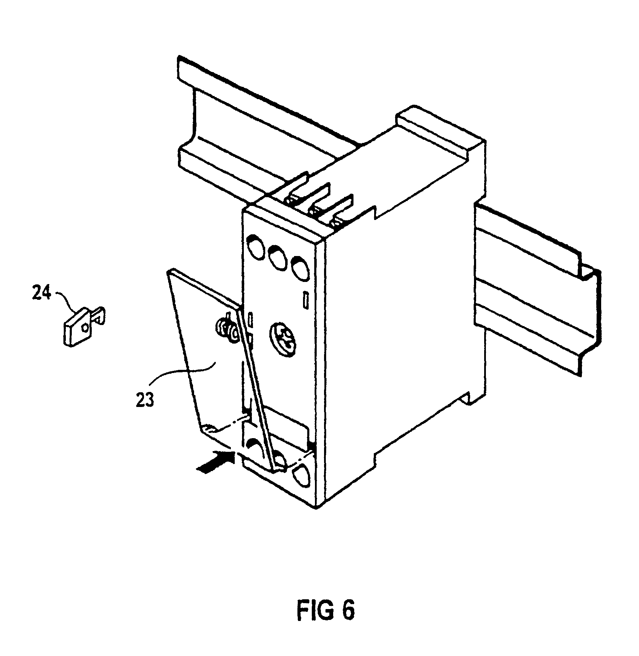

Die einmal vorgenommene Einstellung der Drehknöpfe 19 kann auch durch eine Abdeckung, z.B. ein transparentes Spritzgußteil 23 gemäß FIG 6, vorgenommen werden. Die Abdeckung 23 ist mittels eines Verriegelungsteils 24, das im Gehäuse verhakt wird, plombierbar.

Obwohl die vorliegende Erfindung unter Bezugnahme auf die in der beigefügten Zeichnung dargestellte Ausführungsform erläutert ist, sollte berücksichtigt werden, daß damit nicht beabsichtigt ist, die Erfindung nur auf die dargestellte Ausführungsform zu beschränken, sondern alle möglichen Änderungen, Modifizierungen und äquivalente Anordnungen, soweit sie vom Inhalt der Patentansprüche gedeckt sind, einzuschließen.

## Patentansprüche

1. Elektrisches Gerät mit einem Gehäuse (2), das aus zwei identisch ausgeführten Gehäuseschalen (1) zusammengesetzt ist, die spiegelverkehrt zueinander montiert sind, **dadurch gekennzeichnet, daß** das Gehäuse (2) mit einer Schnappbefestigung zum Aufschnappen einer Montageschiene versehen ist, und daß die Schnappbefestigung durch zwei Federrasthaken (6) realisiert ist, von denen je einer in jeweils einer Gehäuseschale (1) integriert ist.

2. Elektrisches Gerät nach Anspruch 1, **dadurch gekennzeichnet, daß** beide Gehäuseschalen (1) durch angeformte Rastelemente (3,4) verbunden sind.

3. Elektrisches Gerät nach einem der vorangehenden Ansprüche, **dadurch gekennzeichnet, daß** im Innenraum des Gehäuses (2) eine Leiterplatte (10) mit mindestens zwei Klemmenträgern (11) montiert ist, die in die Leiterplatte (10) geschnappt werden und deren zu Anschlußklemmen gehörige Anschlußfahnen (12) durch Verlötung mit der Leiterplatte (10) in elektrischer Verbindung stehen.

4. Elektrisches Gerät nach einem der vorangehenden Ansprüche, **dadurch gekennzeichnet, daß** im elektrischen Gerät Anschlußklemmen integriert sind und zur Erweiterung um weitere Anschlußklemmen jeweils an einer Seitenwand der beiden Gehäuseschalen (1) ein Klemmenblock (15) mit Anschlußklemmen aufrastbar ist, in die bei Aufrastung aus dem Gehäuse (2) hervorragender Anschlußfahnen (12) von Klemmträgern (11) hineingleiten.

5. Elektrisches Gerät nach einem der vorangehenden Ansprüche, **dadurch gekennzeichnet, daß** das Gerät frontseitig mindestens einen Drehknopf (19) als Einstellelement mit einer Verstellsicherung aufweist, die darin besteht, daß auf dem Drehknopf (19) ein mechanisch kodiertes Schild (21) aufrastbar ist, wobei die mechanische Kodierung des Schildes einer bestimmten Stellung des Drehknopfes (19) entspricht.

## Claims

1. Electric appliance having a casing (2) composed of two identically built casing shells (1) mounted in mirror inversion to one another, **characterised in that** the casing (2) is provided with a snap-on mount for snap attachment to a mounting rail, and that the snap-on mount is implemented by two spring locking hooks (6), one of which is integrated into each of the casing shells (1).

2. Electric appliance according to Claim 1, **characterised in that** the two casing shells (1) are joined together by integrally moulded catch elements (3, 4).

3. Electric appliance according to one of the preceding claims, **characterised in that** a circuit board (10) having at least two terminal insulators (11) is mounted in the interior of the casing (2), the terminal insulators being snapped into the circuit board (10) and their terminal lugs (12) belonging to the terminals being electrically connected to the circuit board (10) by soldering.

4. Electric appliance according to one of the preceding claims, **characterised in that** terminals are integrated into the electric appliance and, for adding additional terminals for expansion, a terminal block (15) can be locked onto in each case one side wall of the two casing shells (1), the terminal block having terminals -into which slide the terminal lugs (12) of terminal insulators (11) projecting out of the casing (2) when locked together,

5. Electric appliance according to one of the preceding claims, **characterised in that** the appliance has on the front side at least one turning knob (19) as an adjusting element having an adjustment securing device, where a mechanically coded plate (21) can be locked onto the turning knob (19), with the mechanical coding of the plate corresponding to a certain position of the turning knob (19).

## Revendications

1. Appareil électrique comportant un boîtier (2) qui est composé de deux coquilles (1) de boîtier, qui sont réalisées de manière identique et qui sont montées symétriques comme en un miroir, **caractérisé en ce que** le boîtier (2) est muni d'une fixation par encliquetage pour l'encliquetage d'un rail de montage et **en ce que** la fixation par encliquetage est réalisée par deux crochets (6) d'encliquetage élastiques chacun intégré dans respectivement une coquille (1) de boîtier.

2. Appareil électrique suivant la revendication 1, **caractérisé en ce que** les deux coquilles (1) de boîtier sont reliées par des éléments (3, 4) d'encliquetage moulés.

3. Appareil électrique suivant l'une des revendications précédentes, **caractérisé en ce qu'**il est monté à l'intérieur du boîtier (2) une plaquette (10) à circuit imprimé qui comporte au moins deux supports (11) de borne qui sont encliquetés dans la plaquette (10) à circuit imprimé et dont les oreilles (12) de raccordement faisant partie des bornes de raccordement sont en liaison électrique par brasage avec la plaquette (10) à circuit imprimé.

4. Appareil électrique suivant l'une des revendications précédentes, **caractérisé en ce qu'**il est intégré dans l'appareil électrique des borne de raccordement et **en ce qu'**il peut être encliqueté, pour l'élargissement à des bornes de raccordement supplémentaires, respectivement sur une paroi latérale des deux coquilles (1) de boîtier, un bloc (15) de bornes comportant des bornes de raccordement dans lesquelles glissent, lors de l'encliquetage, des oreilles (12) de raccordement de supports (11) de borne faisant saillie du boîtier (2).

5. Appareil électrique suivant l'une des revendications précédentes, **caractérisé en ce que** l'appareil comporte côté frontal au moins un bouton (19) tournant comme élément de réglage ayant un dispositif de sécurité vis-à-vis d'un mauvais réglage qui consiste **en ce qu'**il peut être encliqueté sur le bouton (19) tournant une plaque (21) codée du point de vue mécanique, le codage mécanique de la plaque correspondant à une position déterminée du bouton (19) tournant.
